(19) **Europäisches Patentamt**
**European Patent Office**
**Office européen des brevets**

(11) **EP 1 867 057 B1**

(12) **EUROPEAN PATENT SPECIFICATION**

(45) Date of publication and mention
of the grant of the patent:
**29.07.2009 Bulletin 2009/31**

(51) Int Cl.:
*H04B 1/30* (2006.01)  *H04L 25/06* (2006.01)

(21) Application number: **06738526.0**

(22) Date of filing: **13.03.2006**

(86) International application number:
**PCT/US2006/009474**

(87) International publication number:
**WO 2006/099531 (21.09.2006 Gazette 2006/38)**

(54) **RECEIVER DC OFFSET CORRECTION**

EMPFÄNGER-DC-OFFSET-KORREKTUR

CORRECTION DU DÉCALAGE CC D'UN RÉCEPTEUR

(84) Designated Contracting States:
**AT BE BG CH CY CZ DE DK EE ES FI FR GB GR HU IE IS IT LI LT LU LV MC NL PL PT RO SE SI SK TR**

(30) Priority: **11.03.2005 US 660968 P**

(43) Date of publication of application:
**19.12.2007 Bulletin 2007/51**

(73) Proprietor: **QUALCOMM INCORPORATED**
**San Diego, California 92121 (US)**

(72) Inventors:
• **RAMASUBRAMANIAN, Nangavalli**
**San Diego, California 92129 (US)**

• **KRISHNAMOORTHI, Raghuraman**
**San Diego, California 92121-1714 (US)**
• **MUKKAVILLI, Krishna, Kiran**
**San Diego,**
**California 92126 (US)**

(74) Representative: **Heselberger, Johannes**
**Patent- und Rechtsanwälte**
**Bardehle - Pagenberg - Dost**
**Altenburg - Geissler**
**Galileiplatz 1**
**81679 München (DE)**

(56) References cited:
**US-A1- 2002 151 289      US-A1- 2002 197 975**
**US-B1- 6 445 736**

**Description**

**Field**

This invention relates generally to wireless communications devices and, more particularly, to a system and method for correcting dc offset errors that occur in the receiver of a communication device.

**Background**

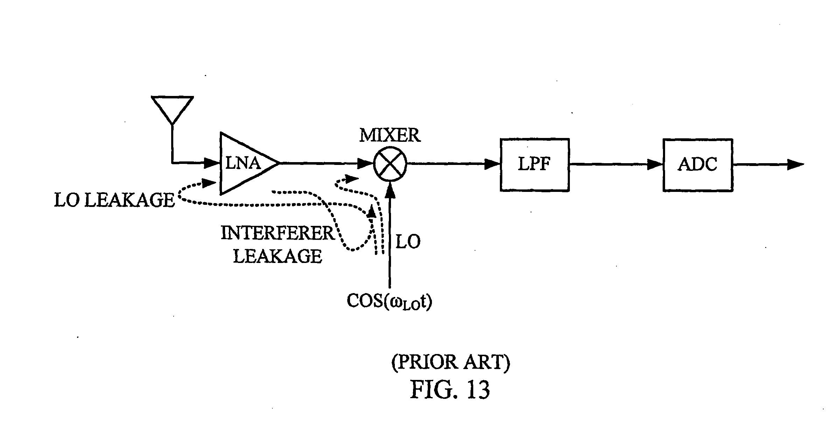

FIG. 13 is a schematic block diagram of a conventional receiver front end (prior art). A conventional wireless communications receiver includes an antenna that converts a radiated signal into a conducted signal. After some initial filtering, the conducted signal is amplified. Given a sufficient power level, the carrier frequency of the signal may be converted by mixing the signal (down-converting) with a local oscillator signal. After frequency conversion, the analog signal may be converted to a digital signal, using an analog-to-digital converter (ADC), for baseband processing. Besides the noise introduced by amplification, the above-mentioned process introduces a dc offset value that is summed with the intended signal, resulting in errors in the interpretation of the intended signal.

The dc offset associated with a zero intermediate frequency (ZIF) receiver may be even more pronounced. The analog mixer is typically the main source of dc offset. Typically, there are mismatches in the current sources that drive the mixer, resulting in a dc offset that varies slightly with temperature. The dc offset is also a function of the mixer gain state. However, it is possible to calibrate for the offset resulting from current sources for a given mixer gain state, then remove the resulting static offset.

The dc offset can also occur as a result of insufficient isolation between the local oscillator (LO) and the radio frequency (RF) front end. This source of error can result in both static and dynamic offsets. Without proper isolation, the LO can leak into the signal path, radiate from the antenna, be reflected by the environment, and lead to self mixing and a static DC offset. Similarly, an interferer can leak into the LO, resulting in a time varying dc offset. Although only a single path is shown, for receivers using quadrature phase modulation, parallel in-phase (I) and out of phase (Q) paths would be used.

The ADC also contributes to the dc offset as a result of uncertainty in the least significant bits (LSBs), although this source of error is typically less than that associated with the mixer. AC coupling cannot be used at the input of the ADC to remove the dc offset, because the capacitance of a coupling capacitor must be large to prevent data subcarrier distortion. Such a capacitor would create long time constants, and would likely be too large in size to fit in many portable receivers. US 6,445,736 B1 discloses a GSM baseband receiver arrangement using digital signal processing. The baseband receiver arrangement comprises two channels for in-phase and quadrature components of the received signal. The DC offset of each channel is separately estimated by accumulating samples from the outputs of the second filter stages and dividing the result by 64. The result is then negated and applied to the digital DC offset controls. This two stage process ensures that the majority DC offset is removed prior to variable gain, and the residual DC offset is removed before digital frequency shifting. Applying DC offset correction before the digital frequency shifting ensures that DC is annulled for any subsequent shift.

It would advantageous if a wireless communications device receiver could be calibrated upon initialization to measure the dc offset error being generated, and to remove the measured error from the received signal.

It would be advantageous if a receiver could continually calibrate itself, even while operating, to measure and removed dc offset errors from the received signal.

**SUMMARY**

A system and method are provided for correcting direct current (dc) offset in a communications receiver. The system comprises two nested first order loops, where one loop (fine correction loop) operates in the digital domain, while the second loop (coarse correction loop) obtains an estimate of the dc bias from the digital samples, and applies the correction in the analog domain. The coarse correction loop operates such that most of the dc bias is removed before the ADC (Analog to Digital Converter), to prevent any saturation at the ADC. The fine correction loop then removes any residual dc bias in the signal after the corrections applied by the coarse correction loop. There is memory built in the system to memorize the corrections to be applied for each gain state of the analog front end in the device. There are two states of operation for the dc correction, which are essentially an initialization (or calibration) state and a tracking (or communication) state. During the calibration state, the received communication signal is disconnected at the input of the analog front end, so that the dc loops can be calibrated to remove the static dc bias arising from the components within the receiver. During the tracking state, the fine correction loop is first updated. Then, the coarse correction loop is updated at a predetermined rate, based on the updates performed on the fine correction loop. These updates are performed for each gain state of the receiver.

Accordingly, a method is provided for correcting dc offset in a wireless communications receiver. The method disconnects the mixer signal input from a received communication signal (i.e., the LNA output) in an initialization state. An analog signal is accepted from the mixer output and converted into digital signal. An initial fine correction value is generated and subtracted from the digital signal. Thus, the digital signal amplitude in minimized in response to the initial fine correction value.

In a communication state the LNA output is connected to the mixer input so that communication signals are received at the mixer signal input. The initial fine correction value is subtracted from a converted digital communication signal, so that the digital communication signal is supplied with an initial fine corrected dc offset.

The method can also be used to generate a coarse correction value in the initialization state. The coarse correction value is used to adjust a current input to the mixer. As with the initial fine correction, the digital signal amplitude is minimized (in the initialization state), in response to the coarse correction value. In the communication state, the communication signal is supplied to the mixer input and the mixer is operated with the coarse value correction. The digital communication signal is then supplied with both coarse and initial fine corrected dc offsets.

In another aspect, a final fine correction is made after the coarse correction is determined. In the initialization state, a final fine correction value in generated while operating the mixer with the coarse value correction. Then, in the communication state, the final fine correction value is subtracted from the digital communication signal, and the digital communication signal is supplied with coarse and final fine corrected dc offsets.

In another aspect, the method generates a tracking correction value while operating in the communication state. The tracking correction value is subtracted from the digital communication signal. The digital communication signal is supplied with coarse and tracking corrected dc offsets. If the communication signal is composed of subcarriers, with a first subcarrier at a first frequency (f1) offset from the carrier, then the correction values are tracked using a bandwidth of less than f1. That is, the tracking corrections are made through a measurement of errors associated with only the carrier frequency.

Additional details of the above-described method, and a system for correcting dc offset in the received communication signals of a wireless communications receiver are provided below.

## BRIEF DESCRIPTION OF THE DRAWINGS

FIG. 1 is a schematic block diagram of a system for correcting direct current (dc) offset in the received communication signals of a wireless communications receiver.

FIG. 2 is a schematic block diagram depicting a general example of a system for correcting dc offset in a received communications signal.

FIG. 3 is a schematic block diagram depicting a general example of a processor device for correcting dc offset in the received communications signal of a wireless communications receiver.

FIG. 4 is a high-level schematic block diagram of an exemplary receiver with the dc offset correction system.

FIG. 5 is a schematic block diagram showing the dc offset correction system, with a more detailed depiction of the first and second loops.

FIG. 6 is a block diagram with a detailed depiction of the first loop.

FIG. 7 is a block diagram with a detailed depiction of the second loop.

FIG. 8 is a timing diagram associated with the coarse correction of a dc offset.

FIG. 9 is a schematic block diagram depicting the correction to inner loop accumulator values during an outer loop tracking update.

FIG. 10 is a schematic block diagram depicting an exemplary implementation of the dc correction loop in hardware.

FIG. 11 is a timing diagram depicting the signal flow for dc correction process.

FIGS. 12A and 12B are flowcharts illustrating a method for correcting dc offset in a wireless communications receiver.

FIG. 13 is a schematic block diagram of a convention receiver front end (prior art).

## DETAILED DESCRIPTION

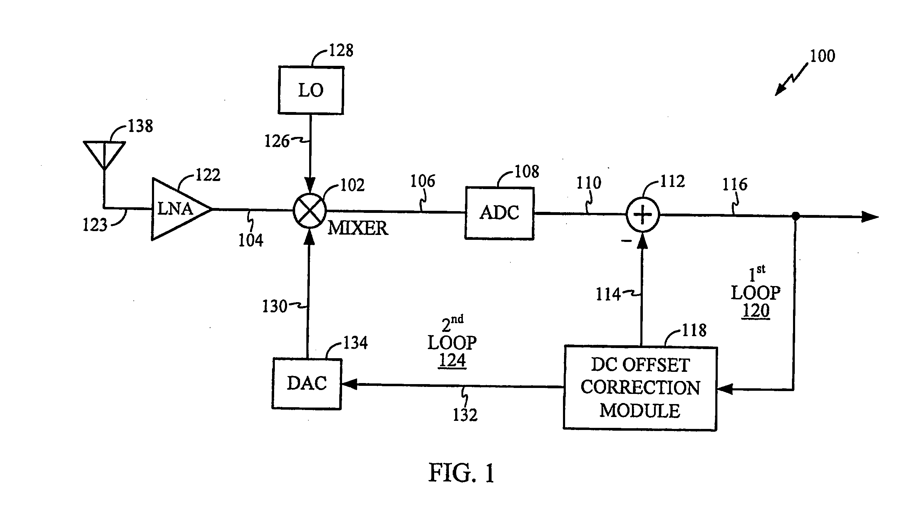

FIG. 1 is a schematic block diagram of a system for correcting direct current (dc) offset in the received communication signals of a wireless communications receiver. The system 100 comprises a mixer 102 having a signal input on line 104 that is selectively disconnected from a received communications signal in an initialization state. The mixer has an analog output on line 106. An analog-to-digital converter (ADC) 108 has an input connected to the mixer output on line 106, and an output on line 110 to supply a digital signal.

A summing circuit 112 has a first input connected to the ADC output on line 110 and a second input on line 114. The summing circuit 112 has an output on line 116 to supply a summed digital signal, where the second input is subtracted from the first input. A dc offset correction module 118 has an input on line 116 to receive the summed digital signal and an output on line 114 to supply an initial fine correction value to the summing circuit second input. The combination of the summing circuit 112 and dc offset module 118 enable the formation of a first loop 120, to minimize the summed digital signal amplitude in the initialization state. Ideally, the summed digital signal amplitude should have no dc bias in the initialization state after the corrections are applied.

The mixer signal input on line 104 is selectively connected to receive a communications signal in a communications state. In some aspects, the selective connection function may be performed by a switch. However, in other aspects the communication signal may be selectively connected to the mixer 102 by applying dc power to circuits preceding the mixer. Here, a low noise amplifier (LNA) 122 is shown. The input signal to the mixer is selectively supplied by dis/connecting dc power to the LNA 122, or dis/connecting the communication signal to the input of the LNA on line 123. Then, the summing circuit 112 subtracts the initial fine correction value from the ADC output on line 110, to supply a digital communications signal with an initial fine corrected dc offset in the communication state.

The assumption behind this correction process is that the dc offset measured in the initialization or acquisition state is also present when communication signals are being received and processed. The assumption continues in expecting that the corrections made to remove the dc offset in the initialization state will improve the signal quality, if applied in the communication state.

In some aspects, the system includes a second loop 124. The mixer 104 has an input on line 126 connected to a local oscillator (LO) 128, and a current supply (dc voltage) input on line 130. The dc offset correction module 118 has an output connected to the mixer current supply input on line 132 for supplying a coarse correction value, to minimize the summed digital signal amplitude in the initialization state. Then, summing circuit 112 supplies a digital communication signal on line 116 with a coarse and an initial fine corrected dc offset in the communication state.

More specifically, the dc offset correction module 118 may generate the coarse correction value on line 132 as an accumulated coarse correction digital value. A digital-to-analog converter (DAC) 134 has an input connected on line 132 to receive the coarse correction digital value and an output connected to the mixer current supply input 130. The process assumes that dc offset measured during initialization can be further reduced by making corrections at the mixer, as well as at the summing circuit. Likewise, this process assumes that the 2-step correction further improves the signal quality, when applied in the receiver communication state.

Typically, the dc offset module 118 scales the fine correction value and supplies the scaled fine correction value as an initial coarse correction value. That is, the initial fine correction value is supplied as a first "guess" for the coarse correction value. Note, the initial fine correction value may be prescaled by a predetermined factor prior to being used as the initial coarse correction value. The second loop 124, beginning with the initial coarse correction value, acquires the (final) coarse correction value, which is the value that creates the lowest signal amplitude from the ADC 108 in the initialization state.

The initialization state correction process can be carried one step further. After the coarse correction value is acquired, the system 100 works to acquire a final fine correction value. The dc offset correction module 118 supplies the final fine correction value to the summing circuit 112 in the initialization state, while supplying the coarse value correction to the mixer 102. Then in the communication state, the summing circuit 112 is able to supply a digital communication signal on line 116 with a coarse and a final fine corrected dc offset.

In one aspect of the system 100, the mixer 102 has a plurality of gain states. The dc offset correction module 118 generates an initial fine correction value, a coarse correction value, and a final fine correction value for each mixer gain state in the initialization state. The summing circuit 112 supplies a digital communications signal on line 116 (in the communication state) with corrected dc offsets corresponding to the mixer gain.

In another aspect, the LNA 122 may have a plurality of gain states. The LNA 122 has an input on line 123 that is connected to a conventional wireless air interface that is shown represented by antenna 138. However, it should be understood that additional duplexer, amplification, and filtering circuitry (not shown) may be associated with the air interface. The LNA has an output connected to the mixer signal input on line 104. The dc offset correction module 118 generates an initial fine correction value, a coarse correction value, and a final fine correction value for each LNA gain state in the initialization state. The summing circuit 112 supplies a digital communications signal on line 116 with corrected dc offsets corresponding to the LNA gain.

In another aspect, the first loop corrections can be further enhanced by modifying the final correction value when the receiver is operating in the communication state. That is, the dc offset correction module 118 supplies a tracking correction value to the summing circuit 112 on line 114 in the communication state, and the summing circuit supplies a digital communication signal on line 116 with coarse and tracking corrected dc offsets in the communication state. In one aspect, the dc offset correction module scales the tracking correction value and supplies the scaled tracking correction value as an updated coarse correction value. In another aspect, tracking corrections are made for every mixer and LNA gain state.

If the communication signal is composed of a carrier signal with information-bearing subcarrers, as is conventional, first loop errors can be tracked using a bandwidth smaller than the first subcarrier frequency offset (the subcarrier closest to the carrier). For example, the mixer signal input on line 104 may be an Orthogonal Frequency Division Multiplexing (OFDM) signal with a first subcarrier at a first frequency (f1) offset from the carrier. Then, the dc offset correction module 118 generates a tracking correction value using a tracking bandwidth of less than f1.

In another aspect, the OFDM signal includes a periodic pilot signal. By applying the tracking correction, the summing circuit 112 is able to supply a digital communication signal on line 116 with a reduced probability of pilot signal false alarms in response to the corrected dc offsets.

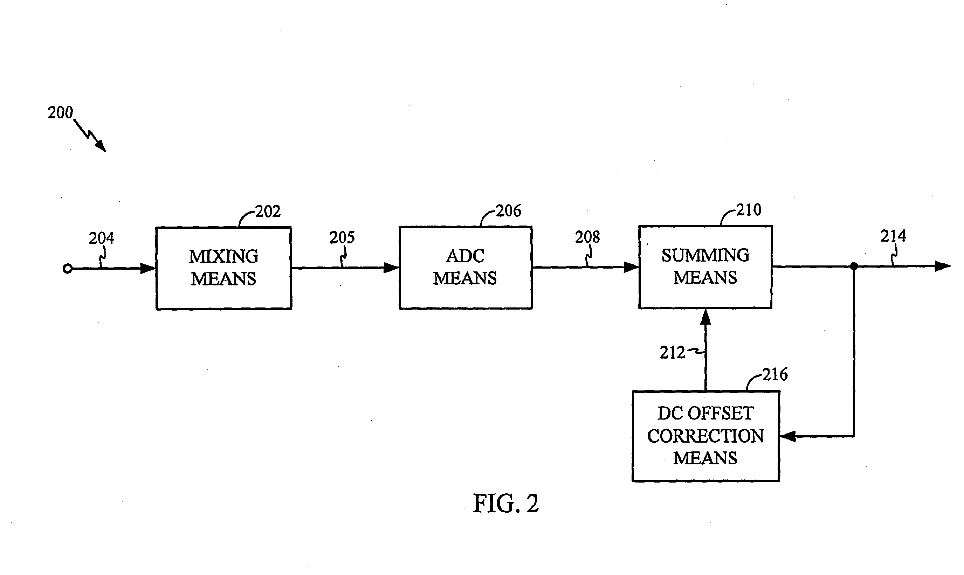

FIG. 2 is a schematic block diagram depicting a general example of a system for correcting dc offset in a received communications signal. The system 200 comprises a means 202 for mixing an input signal with a LO signal. The mixing means 202 has a signal input on line 204 that is selectively disconnected from a received communications signal (by a means not shown) in an initialization state. The mixing means 202 also has an analog output on line 205. The system further comprises a means 206 for converting an analog signal to a digital signal. The ADC means 206 has an input connected to the mixing means output on line 205, and an output on line 208 to supply a digital signal.

A summing means 210 has a first input connected to the output of the ADC means output on line 208. The summing means 210 has a second input on line 212 and an output on line 214 to supply a summed digital signal, where the second input is subtracted from the first input. The system 200 further comprises a means 216 for correcting a dc offset. The dc offset correcting means 216 has an input to receive the signal from the summing means on line 214, and an output on line 212 to supply a fine correction value to the second input of the summing means 210. The fine correction value minimizes the summed digital signal amplitude in the initialization state.

In the communications state, the signal input to the mixing means 202 is selectively connected, permitting the mixing means 202 to receive a communications signal. The summing means 210 subtracts the fine correction value from the output of ADC means 206, to supply a digital communications signal with a fine corrected dc offset in the communication state.

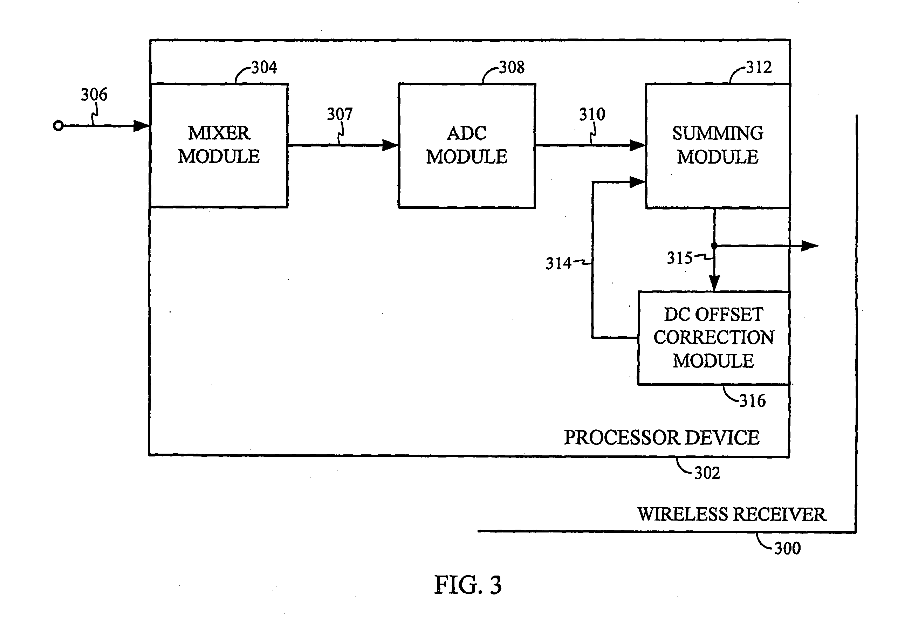

FIG. 3 is a schematic block diagram depicting a general example of a processor device for correcting dc offset in the received communications signal of a wireless communications receiver 300. The processor device 302 comprises a mixer module 304 having a signal input on line 306 that is selectively disconnected from a received communications signal (by a means not shown) in an initialization state. The mixer module 304 has an analog output on line 307. An ADC module 308 has an input connected to the mixer module output on line 307, and an output to supply a digital signal on line 310.

A summing module 312 has a first input connected to the ADC module output on line 310, a second input on line 314, and an output on line 315 to supply a summed digital signal. The summing module 312 subtracts the second input from the first input. A dc offset correction module 316 has an input to receive the summed digital signal on line 316 and an output on line 314 to supply a fine correction value to the summing module second input. The fine correction value is used to minimize the summed digital signal amplitude in the initialization state.

In the communication state, the mixer module signal input on line 306 is selectively connected to receive a communications signal. The summing module 312 subtracts the fine correction value from the ADC module output on line 310, to supply a digital communications signal with a fine corrected dc offset in the communication state.

## Functional Description

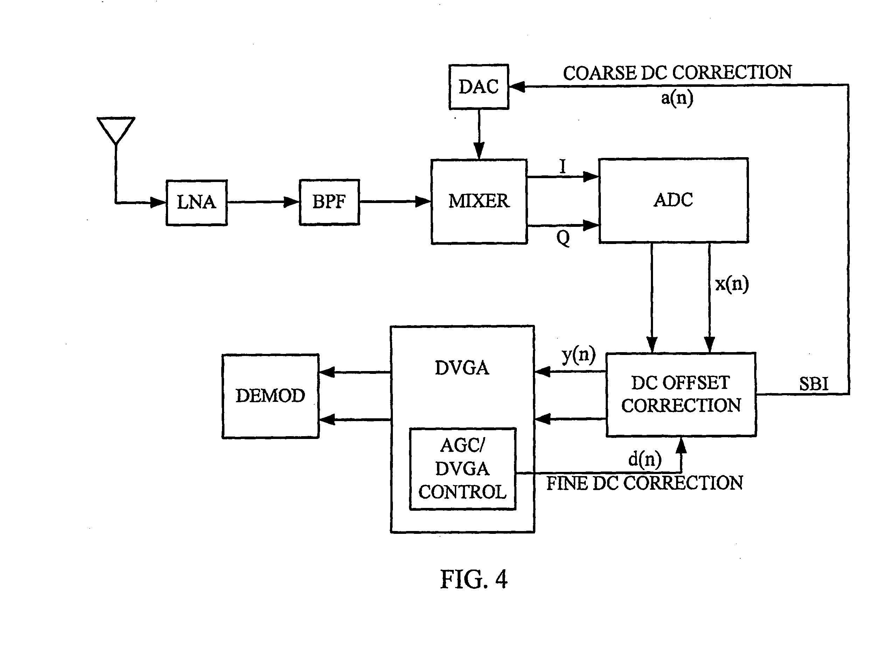

FIG. 4 is a high-level schematic block diagram of an exemplary receiver with the dc offset correction system. The present invention is a design for a receiver with a dc offset correction loop. dc offset is a common impairment in communication receivers, which acts as a slowly varying bias that is added to the received signal. The dc offset may be composed of both static and dynamic components that originate from the radio frequency (RF) front-end mixer stages. The effects of dc offset on a ZIF receiver may be even more pronounced. The negative effects of DC bias on the receiver are two fold: dc offset reduces the permitted dynamic range of the input signal to the ADC, to avoid saturation of the ADC. Further, if the communication signal level is weak compared to the dc offset, the AGC may potentially follow the dc bias, instead of the signal level, when making gain step determinations. Many conventional transmitters do not transmit useful data at dc. Therefore, the suppression in the receiver does not affect the flow of data.

Ideally, a simple first order loop with the ability to correct the dc level of the signal before the ADC input would be sufficient. However, in practice the resolution of the correction that can be applied before the ADC input is limited.

An example of the invention is presented that performs the dc offset correction using two nested first-order loops. A first (inner) loop is used for fine offset corrections, and a second (outer) loop is used for coarse offset correction. Coarse correction is carried out in the analog domain by the outer loop before the signal is fed to the ADC. Fine DC correction is performed by the inner loop for correcting the dc offset after the ADC in the digital domain.

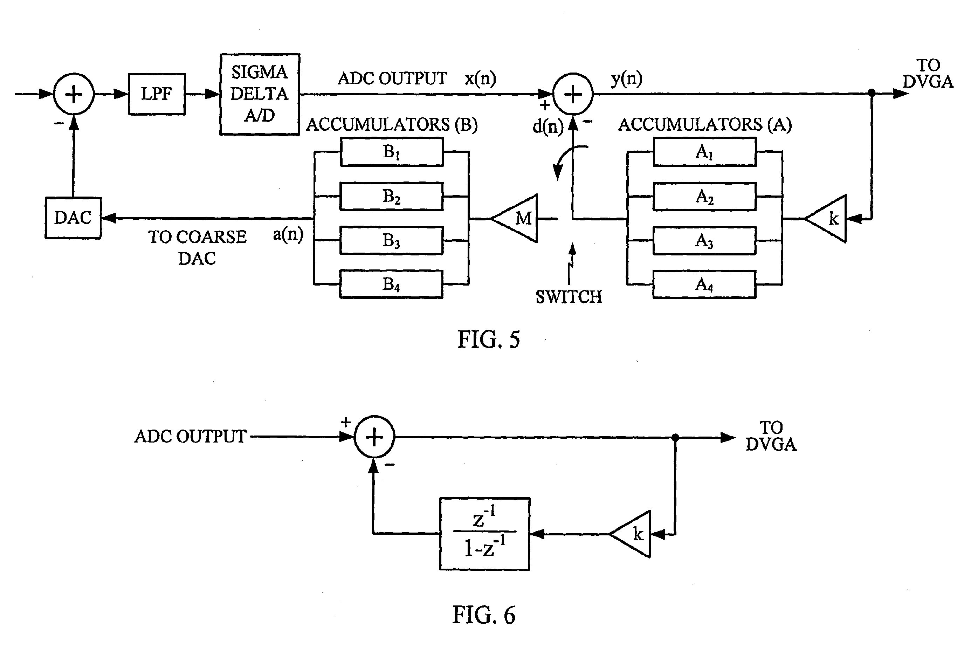

FIG. 5 is a schematic block diagram showing the dc offset correction system, with a more detailed depiction of the first and second loops. The system uses an initialization or acquisition state for calibration, and a tracking state. The inner loop and the outer loops may be engaged in either state. The initialization state is designed to ensure that the outer loop converges so that most of the dc bias is removed before the signal is fed to the ADC, preventing the saturation of the ADC. In tracking mode, the fine correction ensures that the dc offset is removed before the AGC energy measurement, so that the AGC setting is not influenced by the dc bias in the signal. Fine correction is carried out in the digital domain before the signal is fed to the DVGA block (see FIG. 4).

$k_c$ and $k_f$ denote the loop gains of the outer and inner correction loops respectively. The accumulator values in the inner and outer loops for analog gain state $G_i$ are denoted by $A_i$ and $B_i$ respectively; x(n) is the ADC output signal and y(n) is the signal after fine dc correction. The coarse correction signal input to the DAC is denoted by a(n). The digital correction applied by the inner loop is given by d(n). At any time instant n, the values d(n) and a(n) are given by: d(n) = $A_i$(n) and a(n) = $B_i$(n). The value accumulated in the inner loop provides an estimate of the dc offset present in the signal (initial fine correction). This value is used as an error signal to drive the outer loop. Once the outer loop is updated with the inner loop's accumulator value (coarse correction), the accumulators of the inner loop are reset (final fine correction).

The fine dc correction is performed during the initialization (acquisition) and tracking states, by the inner loop in the digital domain. The receiver powers up and starts the initialization state with the LNA off (unpowered). The fine dc offset correction is conducted for all of the gain states of the LNA and all of the gain states of the mixer. During the initialization state (i.e., calibration), accumulators in the (first) digital loop are updated with a suitable loop gain, and the analog offset-correction accumulators (in the second loop) are updated with an appropriate loop gain for each gain state. Then, a signal is sent to the AGC block, indicating the end of digital loop correction. In addition, an enable signal and offset-corrected ADC samples are sent to the AGC block for processing.

After the dc offset is corrected in the initialization state, the dc offset correction enters a tracking state. In the tracking state, the fine offset correction is updated. In some aspects, the coarse dc correction is only updated in the initialization state.

FIG. 6 is a block diagram with a detailed depiction of the first loop. The transfer function of the first order loop is given by $H(z) = \dfrac{1 - z^{-1}}{1 - (1-k)z^{-1}}$. The loop time constant is given by $\tau \approx \dfrac{1}{\left|\ln(1-k)\right|} T_L$ where $T_L$ is the time interval after which the loop is updated. For small values of $k$ such that $k << 1$, the loop time constant is approximated as $\tau \approx \dfrac{T_L}{k}$. The resulting $H(z)$ is essentially a high pass filter that takes out the frequency components around the dc as expected. Further, for the stability of the loop, the loop gain $k$ should be between 0 and 2 (equivalently, $-1 < (1-k) < 1$). This can be readily obtained by observing that the time domain response of the filter is given by $h(n) = -k(1-k)^{n-1}$ for $n > 0$ $h(0) = 1$ and $h(n) = 0$ for $n < 0$. Noting that for stability, $\displaystyle\sum_{n=-\infty}^{\infty} \left|h(n)\right|$ is required to be finite, the result follows. Let $\omega_{3dB}$ be the frequency where the filter gain is 3 dB below its maximum value, which is approximately unity for small values of $k$. Then $\omega_{3dB}$ is given by the solution to $\cos(\omega_{3dB}) = \dfrac{2k - k^2 + 2}{2k + 2}$, for which $\omega$ can be approximated by $\sqrt{\dfrac{k^2}{k+1}}$ when $k$ is small. This can be further approximated to give $\omega_{3dB} \approx k$. Hence, when k is small, both the loop time constant and the bandwidth can be expressed as simple functions of the loop gain $k$.

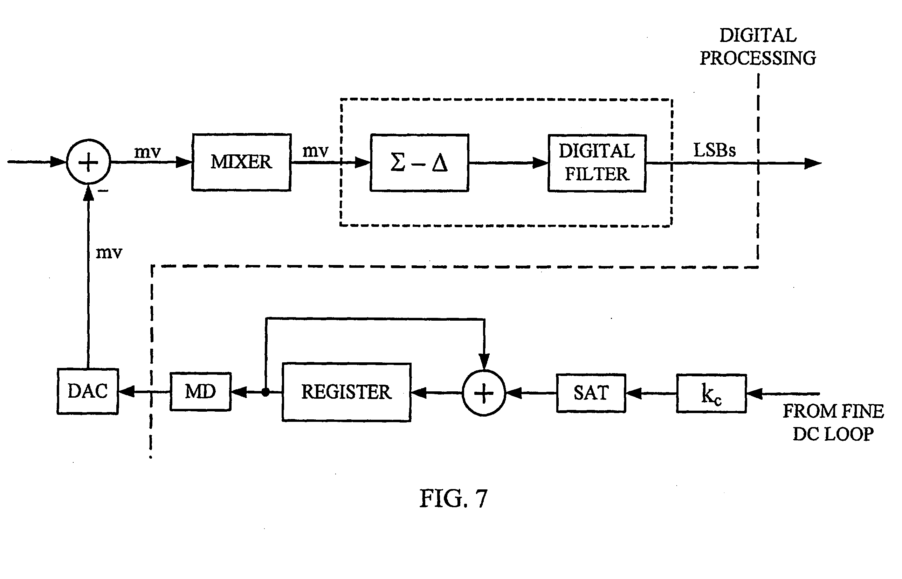

FIG. 7 is a block diagram with a detailed depiction of the second loop. The coarse dc correction loop spans both the digital domain as well as the analog domain. The goal of the coarse correction loop is to cancel out major portion of the dc bias (mainly introduced by the mixer) in the analog domain before the signal is fed to the ADC (i.e., a sigma - delta AGC) to prevent the ADC from saturating. The dc signal is measured in the digital domain and is translated to the analog domain using the gains of the various blocks involved in the loop such as the DAC, mixer, sigma-delta ADC, and the adjustable loop gain to control the overall loop gain.

Accounting for various blocks in the coarse loop, the overall loop gain of the coarse loop is given by :

$$G_{LOOP} = DAC\_gain\,(mv/LSB) \times MixerGain\,(mV/mV) \times$$
$$(Sigma - Delta + Digital\,Filter\,Gain)(LSB/mV) \times 2^{AccShift} \times 2^{-M} \times 2^{(DAC\,bitWidth - Acc\,bitWidth)}$$

Based on the discussion in the previous section, various gain parameters should be such that the overall loop gain lies between 0 and 2. In particular, the required shift M is chosen such that the overall loop gain is less than 1.

$$M = ceil\left(\log_2(DAC\_gain \times G_{MIXER} \times G_{Sigma-Delta+Digital\ Filter\ Gain})\right).$$

Note that the coarse loop includes the mixer, and hence, is affected by the mixer gain changes across states. Correspondingly, the shift parameter $M$ should be adjusted across the mixer gain states so that the overall loop gain is maintained close to the desired value. Hence, during calibration as well as tracking, two different values for $M$ are used, based on the mixer gain state.

**Initial calibration (acquisition)**

The receiver is calibrated to remove the static dc offset, which is a function of the mixer gain state. The calibration takes place every time the receiver enters a different mode of operation, such as power up or switching between CDMA and OFDM. The calibration is carried out for each mixer gain state, and the time taken is less than a fraction of an OFDM symbol for each gain state.

When the receiver is turned on, the outer loop is closed while not letting any signal into the LNA. This helps to measure the resulting static dc offset due to each gain state using the inner loop. Taking out the input signal at the LNA ensures that the ADC does not go into saturation because of a strong input signal. For this operation, a large loop gain $k_f$ is chosen for the inner loop, since there is no concern with attenuating useful frequencies of the signal component.

In one aspect, $k_f = \dfrac{1}{8}$, which corresponds to a time constant of about 8 samples at chip rate when the loop is updated for every sample. Each analog gain state corresponds to one accumulator in bank A and one in bank B. These accumulators are selected based on the analog gain state.

Suppose that the receiver is in gain state $G_i$. Assuming that the inner loop with accumulator $A_i$, requires about 4 time constants for convergence, then about 32 samples are required for the inner loop. However, it could take up to 5 us (approximately 32 samples) for the effect of the analog dc correction to propagate to the ADC output. Therefore, the inner loop requires an additional 32 samples to converge, requiring 64 samples in total.

Taking the DAC gain into account, the stability of the outer loop gain $k_c$ requires that the overall loop gain be less than 2. The outer loop gain parameter is chosen such that the overall loop gain is close to 1. Allowing for some margin, a low gain of 1/4 is assumed. Assuming that $k_c = \dfrac{1}{4}$ for the outer loop, four time constants are required for the outer loop, which corresponds to $4/k_c$ (16) outer loop updates. In order to ensure that both inner and outer loops are converged at the end of the acquisition process, the inner loop needs to be updated after the outer accumulator values are changed. Therefore, after the final outer loop update, the inner loop is updated for 64 samples to ensure convergence of the fine dc accumulators. The outer loop is updated 15 times and after the 15th update, the inner loop is updated for 64 samples. Hence, the outer loop requires $\dfrac{4}{k_c} \times \dfrac{8}{k_f} = 1024$ samples to settle down for each gain state. Note that the switch position in FIG. 5 is changed complete the outer loop once every 64 samples for the first 15 updates.

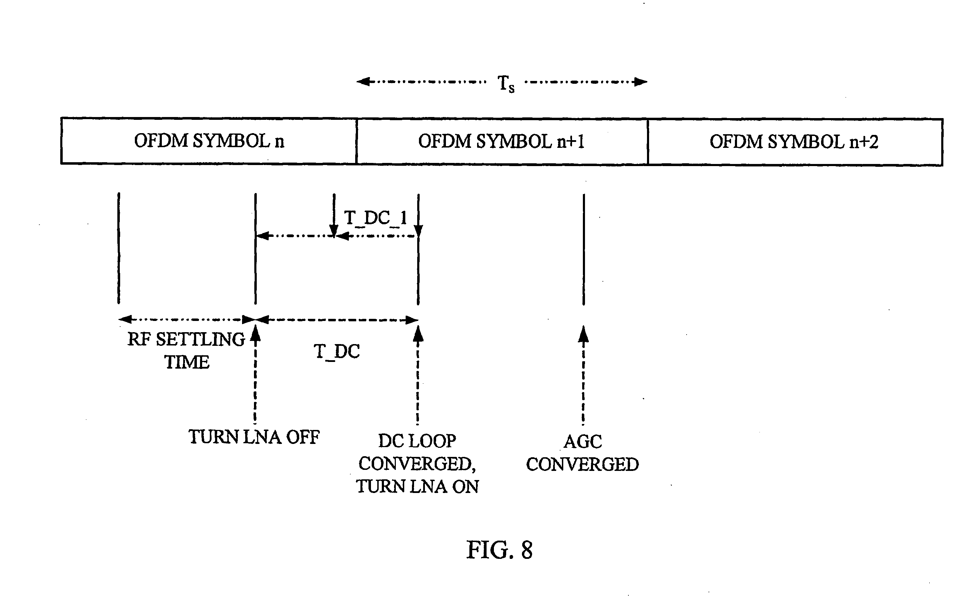

FIG. 8 is a timing diagram associated with the coarse correction of a dc offset. After the accumulator in outer loop ($B_i$) is updated, the switch is set to complete the inner loop. Accumulator contents $B_i$, corresponding to the outer loop, are fed to a DAC, which applies the dc offset correction in the analog domain before the ADC. Hence, when the receiver enters the OFDM mode, the receiver is forced to switch gain steps after every 1024 samples, denoted by T_DC_1. When the receiver is in a given analog gain state, the coarse dc measurement corresponding to that state is carried out and the corresponding accumulator $B_i$ is updated. This is done for each mixer gain state, and the resulting accumulator values are used during tracking for analog correction of the dc offset before the ADC input. The total time taken for calibration is 2.T_DC_1 and is denoted by T_DC. After the acquisition is complete for all the mixer gain states, the values of the coarse and fine accumulators corresponding to un-initialized analog gain states are initialized by copying the coarse and fine accumulator values corresponding to the same mixer gain state. The coarse and fine accumulators for states 0 and 2 are calibrated. The accumulators corresponding to state 1 are initialized by copying the values from the accumulators corresponding to state 0 as both state 0 and 1 have the same mixer gain state. Similarly the accumulators corresponding to state 3 are initialized by copying values from the accumulators corresponding to state 2. Note that in general, the calibration process can be performed over any subset of the analog gain states.

**Tracking correction**

**Inner loop update**

After the initial calibration is complete, the LNA is turned back on, the receiver starts processing the incoming signal, and the inner loop is updated for every sample. One consideration in the design of the inner loop is the resulting $\omega3_{dB}$. The subcarriers on either side of the DC are data subcarriers. To minimize the effect of DC nulling on system performance, $\omega_{3dB}$ must be less than the frequency of the first subcarrier. This ensures that the filter attenuation is not significant at the first OFDM subcarrier. To satisfy this condition, $\omega_{3dB}$ is set to half the frequency of the first subcarrier.

Further, if the loop is updated for every sample, then $T_L = \dfrac{1}{W}$, where $W = 5.55 MHz$ is the overall communication bandwidth, and the normalized frequency of the first carrier is given by $\dfrac{1}{4096}$, where 4096 corresponds to the number

of subcarriers.

Setting $\omega_{3dB}$ as half the frequency of the first subcarrier, $k \approx \dfrac{\pi}{4096}$. This value corresponds to a loop time

constant of $\tau \approx \dfrac{T_L}{k}$, resulting in $\tau = 0.28 T_s$ where $T_s$ is the OFDM symbol duration (833.33 μs). Assuming that four

time constants are needed to settle the loop, it takes at least one OFDM symbol duration for the loop to stabilize when the AGC is in a given gain step. When the gain state changes to i, register $A_i$ in bank A is selected. Register $A_i$ starts off with the value accumulated when the receiver was last in same gain state.

**Outer loop update**

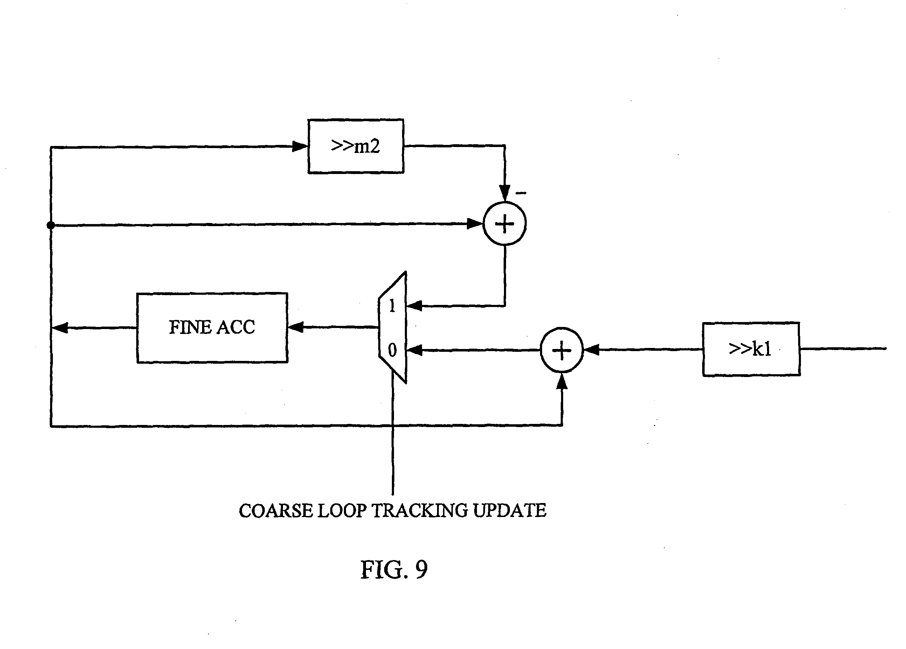

FIG. 9 is a schematic block diagram depicting the correction to inner loop accumulator values during an outer loop tracking update. The registers in bank B, which corresponding to the coarse dc correction, are periodically updated based on the accumulated error in bank A. The typical update rate is once every wakeup. All the registers in bank B are updated every wakeup. The registers in bank A are scaled down at every update of the outer loop. If the inner loop accumulators are not scaled down every update, then the inner loop accumulator value, which corresponds to unused gain states, remains unchanged at every coarse loop update. Therefore, the outer accumulators corresponding to the unused gain states will eventually saturate. Hence, the outer loop update during tracking requires the following operations:

$$B_i(n) = B_i(n-1) + k_c.A_i(n)$$

$$A_i(n+1) = (1-k_c).A_i(n)$$

Equivalently,

$$B_i(n) = B_i(n-1) + A_i(n) >> M2$$

$$A_i(n+1) = A_i(n) - A_i(n) >> M2$$

where M2 is chosen based on the loop gain of the outer dc loop.

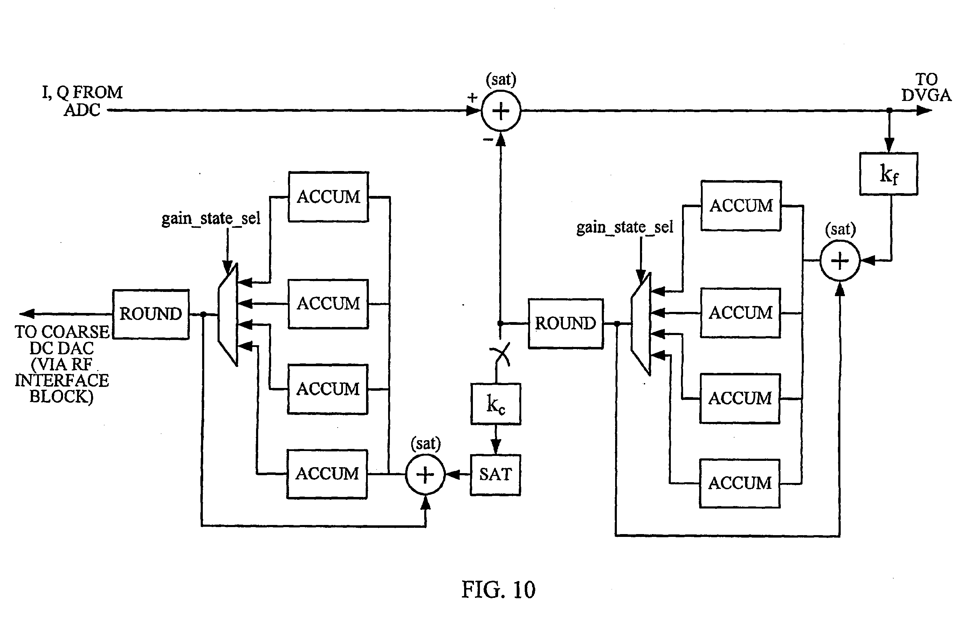

FIG. 10 is a schematic block diagram depicting an exemplary implementation of the dc correction loop in hardware.

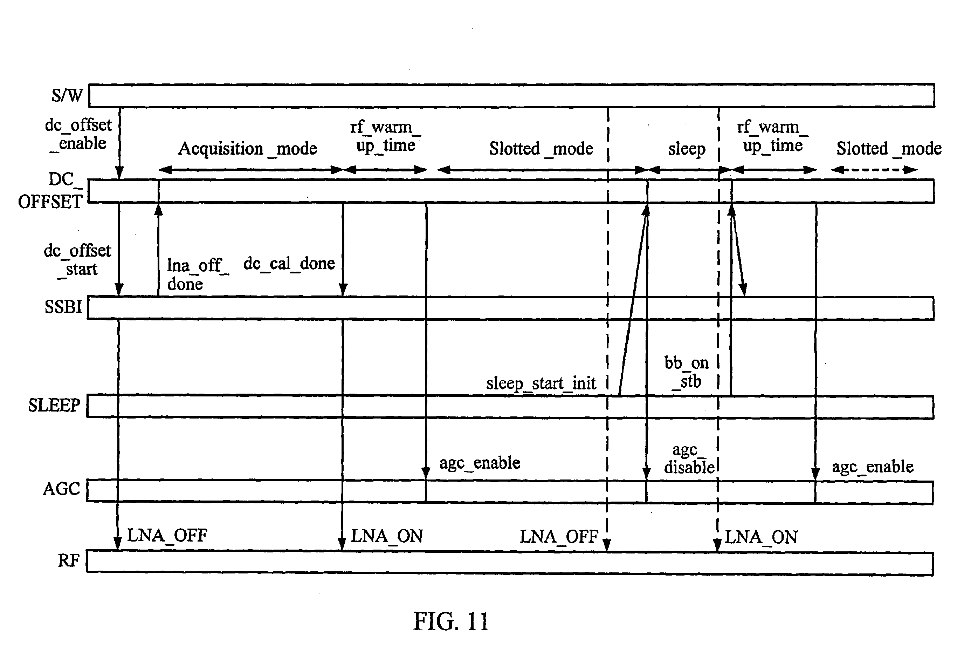

FIG. 11 is a timing diagram depicting the signal flow for dc correction process. On start-up, the accumulators in the first and second loops are reset. After initial power-up, the LNA is initially put in the OFF condition, ensuring that the dc offset in the input signal is corrected before any sample (communication signal) is applied to the AGC block for processing.

The dc offset loops are enabled by software after the LNA is turned off. There are two dc correction loops in the block: a digital (fine) loop correction, also referred to herein as the first loop; and, an analog (coarse) loop correction, also referred to herein as the second loop. In this example, there are four levels of accumulators for each of the fine and coarse correction loops, corresponding to the gain stages of the LNA and the mixer. That is, it is assumed that there are two gain stages for the LNA and two gain stages for the mixer. The accumulation lengths of the fine accumulators for each gain stage and the accumulation length of coarse accumulators during the calibration mode are programmable by software. During the initialization state, the dc offset is corrected for gain stages 0 and 1. At the end of the initialization state, the calibrated values are updated for accumulators of gain stages 3 and 4.

During the initialization state, the coarse accumulators are updated with the fine loop corrected values at the end of a programmed accumulation length. After updating the four sets of accumulators for the programmed length, the coarse dc corrected values are applied to the mixer. Note, although only analog corrections to the mixer have been discussed, in other aspects of the system corrections can be applied to other active circuit elements (i.e., the LNA). After the initialization state corrections are performed, tracking state corrections can be made.

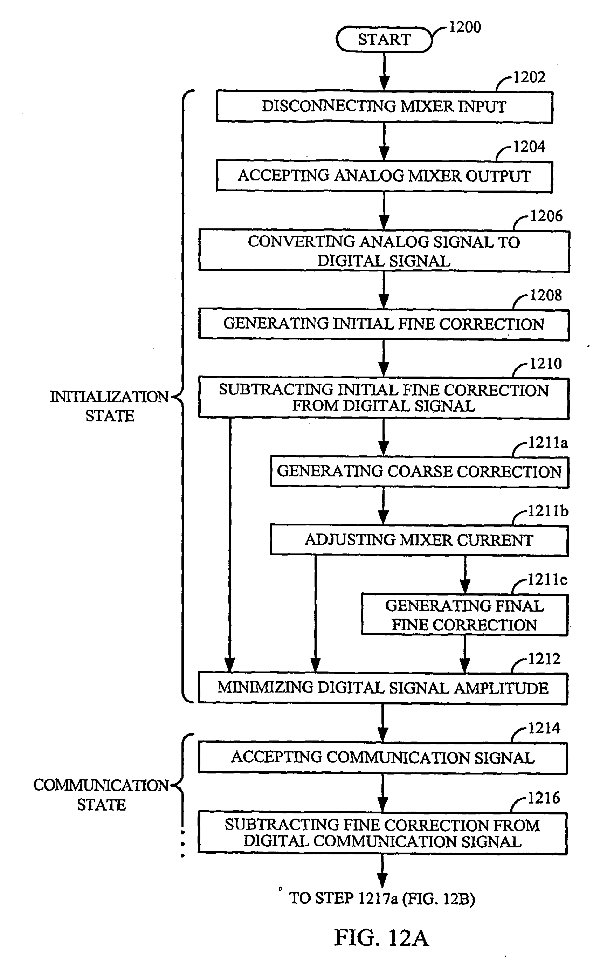

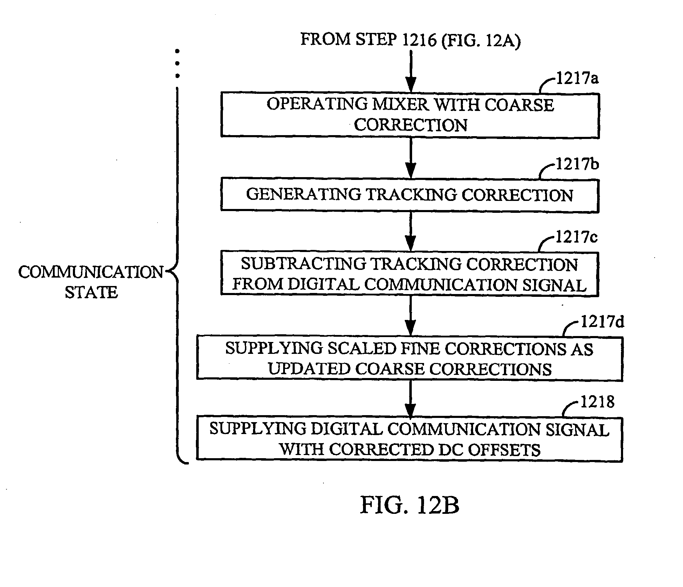

FIGS. 12A and 12B are flowcharts illustrating a method for correcting dc offset in a wireless communications receiver. Although the method is depicted as a sequence of numbered steps for clarity, the numbering does not necessarily dictate the order of the steps. It should be understood that some of these steps may be skipped, performed in parallel, or performed without the requirement of maintaining a strict order of sequence. The method starts at Step 1200.

In an initialization state, Step 1202 disconnects a mixer signal input from a received communication signal. Step 1204 accepts an analog signal from a mixer output. Step 1206 converts the analog signal to a digital signal. Step 1208 generates an initial fine correction value. Step 1210 subtracts the initial fine correction value from the digital signal. Step 1212 minimizes the digital signal amplitude in response to the initial fine correction value. In a communication state, Step 1214 accepts the communication signal at the mixer signal input. Step 1216 subtracts the initial fine correction value from a converted digital communication signal. Step 1218 supplies the digital communication signal with an initial fine corrected dc offset.

In one aspect, Step 1211a generates a coarse correction value in the initialization state. For example, Step 1211a may generate a scaled fine correction value and supply the scaled fine correction value as an initial coarse correction value. Step 1211b uses the coarse correction value to adjust a current input to the mixer, and Step 1212 minimizes the digital signal amplitude in response to the coarse correction value. Step 1217a operates the mixer with the coarse value correction, and Step 1218 supplies the digital communication signal with coarse and initial fine corrected dc offsets.

In another aspect while in the initialization state, Step 1211c generates a final fine correction value while operating the mixer with the coarse value correction. Step 1216 subtracts the final fine correction value from the digital communication signal in the communication state, and Step 1218 supplies the digital communication signal with coarse and final fine corrected dc offsets.

In one aspect, accepting the analog signal from the mixer output in Step 1204 includes accepting an analog signal from a mixer with a plurality of gains. Then, generating the initial fine correction value in Step 1208 includes generating an initial fine correction value for each mixer gain. Generating the coarse correction value in Step 1211a includes generating a coarse correction value for each mixer gain, and generating the final fine correction value in Step 1211c includes generating a final fine correction value for each mixer gain. Then, Step 1218 supplies the digital communication signal with corrected dc offsets corresponding to the mixer gain.

Likewise, Step 1202 may accept the communication signal at the mixer signal input from a LNA with a plurality of gains. Then, generating the initial fine correction value in Step 1208 includes generating an initial fine correction value for each LNA gain. Generating the coarse correction value in Step 1211a includes generating a coarse correction value for each LNA gain, and generating the final fine correction value in Step 1211c includes generating a final fine correction value for each LNA gain. Then, Step 1218 supplies the digital communication signal with corrected dc offsets corresponding to the LNA gain.

In one aspect, generating the coarse correction value in Step 1211a includes substeps (not shown). Step 1211a1 generates an error represented by an accumulated coarse correction digital value. Step 1211a2 converts the coarse correction digital value to an analog correction value, and Step 1211a3 sums the analog correction value with a current input to the mixer.

In another aspect while in the communication state, Step 1217b generates a tracking correction value. Step 1217c subtracts the tracking correction value from the digital communication signal, and Step 1218 supplies the digital communication signal with coarse and tracking corrected dc offsets. In one aspect, Step 1217d scales the tracking correction value and supplies the scaled tracking correction value as an updated coarse correction value. In one aspect, tracking corrections can be made for each LNA and mixer gain state. If Step 1202 a signal with a first subcarrier at a first frequency (f1) offset from the carrier (i.e., an OFDM signal), then Step 1217b tracks correction values using a tracking bandwidth of less than f1. If the OFDM signal includes a periodic pilot signal, then supplying the digital communication signal in Step 1218 includes increasing the probability of acquiring pilot signals in response to supplying a digital communications signal with corrected dc offsets.

Alternately, the flowchart of FIGS. 12A and 12B may be considered to be a representation of a signal bearing medium tangibly embodying a program of machine-readable instructions executable by a digital processing apparatus to perform operations for correcting dc offset in a portable wireless communications receiver.

A system and method have been provided for correcting dc offset in a wireless communications receiver. Some specific examples of designs, circuitry, and underlying assumptions have been presented to illustrate the invention. However, the invention is not limited to merely these examples. Although explained in the context of a wireless receiver, the invention has application in other types of receivers. Other variations and embodiments of the invention will occur to those skilled in the art.

**Claims**

1. A method for correcting direct current (dc) offset in a wireless communications receiver (100), the method comprising:

   in a communication state, accepting a communication signal (104) at a mixer (102) signal input;
   operating the mixer (102) with a coarse value correction (130);
   accepting an analog communication signal from a mixer output (106) and converting it to a digital communication signal (110);
   subtracting a fine correction value (114) from the analog-to-digital converted communication signal; and,
   supplying the digital communication signal (116) with coarse and initial fine corrected dc offsets.

2. The method of claim 1 further comprising: in an initialization state occurring prior to the communication state, disconnecting the mixer signal input from the received communication signal; accepting an analog signal from a mixer output; converting the analog signal to a digital signal; generating the initial fine correction value; subtracting the initial fine correction value from the digital signal; and, minimizing the digital signal amplitude in response to the initial fine correction value.

3. The method of claim 2 further comprising: in the initialization state, generating a coarse correction value; using the coarse correction value to adjust a current input to the mixer; wherein minimizing the digital signal amplitude includes minimizing the digital signal amplitude in response to the coarse correction value..

4. The method of claim 3 wherein generating the coarse correction value includes using a scaled version of the initial fine correction value as the initial coarse value.

5. The method of claim 3 further comprising: in the initialization state, generating a final fine correction value while operating the mixer with the coarse value correction; wherein subtracting the fine correction value from the digital communication signal includes subtracting the final fine correction value from the digital communication signal; and, wherein supplying the digital communication signal includes supplying the digital communication signal with coarse and final fine corrected dc offsets.

6. The method of claim 5 wherein accepting the analog signal from the mixer output includes accepting an analog signal from a mixer with a plurality of gains; wherein generating the initial fine correction value includes generating an initial fine correction value for each mixer gain; wherein generating the coarse correction value includes generating a coarse correction value for each mixer gain; wherein generating the final fine correction value includes generating a final fine correction value for each mixer gain; and, wherein supplying the digital communication signal includes supplying the digital communication signal with corrected dc offsets corresponding to the mixer gain.

7. The method of claim 5 wherein accepting the communication signal at the mixer signal input includes accepting the communication signal from a low noise amplifier (LNA) with a plurality of gains; wherein generating the initial fine correction value includes generating an initial fine correction value for each LNA gain; wherein generating the coarse correction value includes generating a coarse correction value for each LNA gain; wherein generating the final fine correction value includes generating a final fine correction value for each LNA gain; and, wherein supplying the digital communication signal includes supplying the digital communication signal with corrected dc offsets corresponding to the LNA gain.

8. The method of claim 7 further comprising: in the communication state, generating a tracking correction value; subtracting the tracking correction value from the digital communication signal; and, wherein supplying the digital communication signal includes supplying the digital communication signal with coarse and tracking corrected dc offsets.

9. The method of claim 8 further comprising: using a scaled version of the tracking correction value to update the coarse correction value.

10. The method of claim 8 wherein accepting the communication signal at the mixer signal input includes accepting an Orthogonal Frequency Division Multiplexing (OFDM) signal with a first subcarrier at a first frequency (fl) offset from the carrier; wherein generating a tracking correction value includes tracking correction values using a tracking bandwidth of less than fl.

11. The method of claim 8 wherein accepting the communication signal includes accepting an OFDM signal with a periodic pilot signal; and, wherein supplying the digital communication signal includes increasing the probability of acquiring pilot signals in response to supplying a digital communications signal with corrected dc offsets.

12. The method of claim 5 wherein generating the coarse correction value includes: generating an error represented by an accumulated coarse correction digital value; converting the coarse correction digital value to an analog correction value; and, summing the analog correction value with a current input to the mixer.

13. Computer program for performing a method according to any of the claims 1 to 12.

14. A system for correcting direct current (dc) offset in a received communications signal for use in a wireless communications receiver, the system comprising:

means for accepting a communication signal (104) at a mixer (102) signal input in a communication state;
means for operating the mixer (102) with a coarse value correction (130);
means for accepting an analog communication signal from a mixer output (106) and converting it to a digital communication signal (110);
means for subtracting a fine correction value (114) from the analog-to-digital converted communication signal; and,
means for supplying the digital communication signal (116) with coarse and initial fine corrected dc offsets.

15. The system of claim 14, further comprising means for performing a method according to any of the claims 1 to 12.

**Patentansprüche**

1. Verfahren zum Richtigstellen des Gleichstrom-Offsetwertes in einem drahtlosen Kommunikationsempfänger (100), aufweisend:

Annehmen eines Kommunikationssignals (104) an einem Signaleingang eines Mixers (102) in einem Kommunikationszustand;
Betreiben des Mixers (102) mit einem groben Korrekturwert (130);
Annehmen eines analogen Kommunikationssignals von einem Mixerausgang (106) und Umwandeln in ein digitales Kommunikationssignal (110);
Abziehen eines feinen Korrekturwertes (114) von dem analog zu digital umgewandelten Kommunikationssignal; und,
Versorgen des digitalen Kommunikationssignals (116) mit groben und anfänglichen feinen richtiggestellten Gleichstrom-Offsetwerten.

2. Verfahren nach Anspruch 1 ferner aufweisend:

in einem Initialisierungszustand, der vor dem Kommunikationszustand stattfindet, Abkoppeln des Mixersignaleingangs von dem empfangenen Kommunikationssignal;

Annehmen eines Analogsignals von einem Mixerausgang;

Umwandeln des Analogsignals zu einem Digitalsignal;

Erzeugen des anfänglichen feinen Korrekturwertes;

Abziehen des anfänglichen feinen Korrekturwertes von dem digitalen Signal; und,

Minimieren der Amplitude des Digitalsignals als Antwort auf den anfänglichen feinen Korrekturwert.

3. Verfahren nach Anspruch 2 ferner aufweisend:

Erzeugen eines groben Korrekturwertes in dem Initialisierungszustand;

Verwenden des groben Korrekturwertes zum Anpassen eines Stroms der dem Mixer zugeführt wird;

wobei das Minimieren der Amplitude des Digitalsignals das Minimieren der Amplitude des Digitalsignals als Antwort auf den groben Korrekturwert umfasst.

4. Verfahren nach Anspruch 3, wobei das Erzeugen des groben Korrekturwertes das Verwenden einer skalierten Version des anfänglichen feinen Korrekturwertes als anfänglichen groben Wertes umfasst.

5. Verfahren nach Anspruch 3 ferner aufweisend:

Erzeugen eines finalen feinen Korrekturwertes während des Betreibens des Mixers mit dem groben Korrekturwert in dem Initialisierungszustand;

wobei das Abziehen des feinen Korrekturwertes von dem digitalen Kommunikationssignal das Abziehen des finalen feinen Korrekturwertes von dem digitalen Kommunikationssignal umfasst; und,

wobei das Versorgen des digitalen Kommunikationssignals das Versorgen des digitalen Kommunikationssignals mit groben und finalen feinen richtiggestellten Gleichstrom-Offsetwerten umfasst.

6. Verfahren nach Anspruch 5,

wobei das Annehmen des Analogsignals von dem Mixerausgang das Annehmen eines Analogsignals von einem Mixer mit einer Vielzahl von Verstärkungsfaktoren umfasst;

wobei das Erzeugen des anfänglichen feinen Korrekturwertes das Erzeugen eines anfänglichen feinen Korrekturwertes für jeden Verstärkungsfaktor des Mixers umfasst;

wobei das Erzeugen des groben Korrekturwertes das Erzeugen eines groben Korrekturwertes für jeden Verstärkungsfaktor des Mixers umfasst;

wobei das Erzeugen des finalen feinen Korrekturwertes das Erzeugen eines finalen feinen Korrekturwertes für jeden Verstärkungsfaktor des Mixers umfasst; und,

wobei das Versorgen des digitalen Kommunikationssignals das Versorgen des digitalen Kommunikationssignals mit richtiggestellten, dem Mixerverstärkungsfaktor entsprechend, Gleichstrom-Offsetwerten umfasst.

7. Verfahren nach Anspruch 5,

wobei das Annehmen des Kommunikationssignals am Mixersignaleingang das Annehmen des Kommunikationssignals von einem Verstärker mit niedrigem Rauschen (low noise amplifier LNA) mit einer Vielzahl von Verstärkungsfaktoren umfasst;

wobei das Erzeugen des anfänglichen feinen Korrekturwertes das Erzeugen eines anfänglichen feinen Korrekturwertes für jeden LNA-Verstärkungsfaktor umfasst;

wobei das Erzeugen des groben Korrekturwertes das Erzeugen eines groben Korrekturwertes für jeden LNA-Verstärkungsfaktor umfasst;

wobei das Erzeugen des finalen feinen Korrekturwertes das Erzeugen eines finalen feinen Korrekturwertes für jeden LNA-Verstärkungsfaktor umfasst; und,

wobei das Versorgen des digitalen Kommunikationssignals das Versorgen des digitalen Kommunikationssignals mit richtiggestellten, dem LNA-Verstärkungsfaktor entsprechend, Gleichstrom-Offsetwerten umfasst.

8. Verfahren nach Anspruch 7 ferner aufweisend:

Erzeugen eines Verfolgungskorrekturwertes (tracking correction value) in dem Kommunikationszustand;

Abziehen des Verfolgungskorrekturwertes von dem digitalen Kommunikationssignal; und,

wobei das Versorgen des digitalen Kommunikationssignals das Versorgen des digitalen Kommunikationssignals mit groben und Verfolgungsrichtiggestellten Gleichstrom-Offsetwerten umfasst.

9. Verfahren nach Anspruch 8 ferner aufweisend:

Verwenden einer skalierten Version des Verfolgungskorrekturwertes zum Aktualisieren des groben Korrekturwertes.

10. Verfahren nach Anspruch 8,
wobei das Annehmen des Kommunikationssignals an dem Signaleingang des Mixers das Annehmen eines orthogonalen Frequenzmultiplex (OFDM) Signals mit einem ersten Unterträger mit einem ersten Frequenz-Offsetwert (f1) relativ zum Träger umfasst;
wobei das Erzeugen eines Verfolgungskorrekturwertes das Verfolgen von Korrekturwerten unter Verwendung einer Verfolgungsbandbreite niedriger als f1 umfasst.

11. Verfahren nach Anspruch 8,
wobei das Annehmen des Kommunikationssignals das Annehmen eines OFDM-Signals mit einem periodischen Pilotsignals umfasst; und,
wobei das Versorgen des digitalen Kommunikationssignals das Erhöhen der Wahrscheinlichkeit des Erlangens von Pilotsignalen als Antwort auf das Versorgen eines digitalen Kommunikationssignals mit richtiggestellten Gleichstrom-Offsetwerten umfasst.

12. Verfahren nach Anspruch 5, wobei das Erzeugen des groben Korrekturwertes umfasst:

Erzeugen eines Fehlers, der einem akkumulierten groben digitalen Korrekturwert entspricht;
Konvertieren des groben digitalen Korrekturwertes zu einem analogen Korrekturwert; und,
Summieren des analogen Korrekturwertes mit einem Strom am Mixereingang.

13. Computerprogramm zum Ausführen eines Verfahrens nach einem der Ansprüche 1 bis 12.

14. System zum Richtigstellen eines Gleichstrom-Offsetwertes in einem empfangenen Kommunikationssignals zum Verwenden in einem drahtlosen Kommunikationsempfänger, wobei das System aufweist:

Mittel zum Annehmen eines Kommunikationssignals (104) an einem Signaleingang eines Mixers (102) in einem Kommunikationszustand;
Mittel zum Betreiben des Mixers (102) mit einem groben Korrekturwert (130);
Mittel zum Annehmen eines analogen Kommunikationssignals von einem Mixerausgang (106) und umwandeln in ein digitales Kommunikationssignal (110);
Mittel zum Abziehen eines feinen Korrekturwertes (114) von dem analog zu digital umgewandelten Kommunikationssignal; und,
Mittel zum Versorgen des digitalen Kommunikationssignals (116) mit groben und anfänglichen feinen richtiggestellten Gleichstrom-Offsetwerten.

15. System nach Anspruch 14, ferner aufweisend Mittel zum Ausführen eines Verfahrens nach einem der Ansprüche 1 bis 12.

**Revendications**

1. Un procédé pour corriger le décalage en courant continu (dc) dans un récepteur de communications sans fil (100), le procédé comprenant :

dans un état de communication, l'acceptation d'un signal de communication (104) sur l'entrée de signal d'un mélangeur (102) ;
la mise en oeuvre du mélangeur (102) avec une correction de valeur grossière (130) ;
l'acceptation d'un signal de communication analogique issu d'une sortie du mélangeur (106) et la conversion de celle-ci en un signal de communication numérique (110) ;
la soustraction d'une valeur de correction fine (114) du signal de communication converti d'analogique en numérique ; et

la délivrance du signal de communication numérique (116) avec des décalages dc corrigés grossier et fin initial.

**2.** Le procédé de la revendication 1, comprenant en outre : dans un état d'initialisation intervenant avant l'état de communication, la déconnexion de l'entrée de signal du mélangeur d'avec le signal de communication reçu ; l'acceptation d'un signal analogique issu d'une sortie du mélangeur ; la conversion du signal analogique en un signal numérique ; la génération de la valeur de correction fine initiale ; la soustraction de la valeur de correction fine initiale du signal numérique ; et la minimisation de l'amplitude du signal numérique en réponse à la valeur de correction fine initiale.

**3.** Le procédé de la revendication 2, comprenant en outre : à l'état d'initialisation, la génération d'une valeur de correction grossière ; l'utilisation de la valeur de correction grossière pour ajuster une entrée de courant vers le mélangeur ; dans lequel la minimisation de l'amplitude du signal numérique inclut la minimisation de l'amplitude du signal numérique en réponse à la valeur de correction grossière.

**4.** Le procédé de la revendication 3, dans lequel la génération de la valeur de correction grossière comprend l'utilisation d'une version mise à l'échelle de la valeur de correction fine initiale comme valeur grossière initiale.

**5.** Le procédé de la revendication 3, comprenant en outre : à l'état d'initialisation, la génération d'une valeur de correction fine finale tout en mettant en oeuvre le mélangeur avec la correction de valeur grossière ; dans lequel la soustraction de la valeur de correction fine du signal de communication numérique inclut la soustraction de la valeur de correction fine finale du signal de communication numérique ; et dans lequel la délivrance du signal de communication numérique comprend la délivrance du signal de communication numérique avec des décalages dc corrigés grossiers et fins finals.

**6.** Le procédé de la revendication 5, dans lequel l'acceptation du signal analogique issu de la sortie du mélangeur comprend l'acceptation d'un signal analogique d'un mélangeur avec une pluralité de gains ; dans lequel la génération de la valeur de correction fine initiale comprend la génération d'une valeur de correction fine initiale pour chaque gain du mélangeur ; dans lequel la génération de la valeur de correction grossière comprend la génération d'une valeur de correction grossière pour chaque gain du mélangeur ; dans lequel la génération de la valeur de correction fine finale comprend la génération d'une valeur de correction fine finale pour chaque gain du mélangeur ; et dans lequel la délivrance du signal de communication numérique comprend la délivrance du signal de communication avec des décalages dc corrigés correspondants au gain du mélangeur.

**7.** Le procédé de la revendication 5, dans lequel l'acceptation du signal de communication sur l'entrée de signal du mélangeur comprend l'acceptation du signal de communication issu d'un amplificateur faible bruit (LNA) avec une pluralité de gains ; dans lequel la génération de la valeur de correction fine initiale comprend la génération d'une valeur de correction fine initiale pour chaque gain du NA ; dans lequel la génération de la valeur de correction grossière comprend la génération d'une valeur de correction grossière pour chaque gain du LNA ; dans lequel la génération de la valeur de correction fine finale comprend la génération d'une valeur de correction fine finale pour chaque gain du LNA ; et dans lequel la délivrance du signal de communication numérique comprend la délivrance du signal de communication numérique avec des décalages dc corrigés correspondant au gain du LNA.

**8.** Le procédé de la revendication 7, comprenant en outre : à l'état de communication, la génération d'une valeur de correction de poursuite ; la soustraction de la valeur de correction de poursuite du signal de communication numérique ; et dans lequel la délivrance du signal de communication numérique comprend la délivrance du signal de communication numérique avec des décalages dc corrigés grossier et de poursuite.

**9.** Le procédé de la revendication 8, comprenant en outre : l'utilisation d'une version mise à l'échelle de la valeur de correction de poursuite pour mettre à jour la valeur de correction grossière.

**10.** Le procédé de la revendication 8, dans lequel l'acceptation du signal de communication sur l'entrée de signal du mélangeur comprend l'acceptation d'un signal à multiplexage par division en fréquences orthogonales (OFDM) avec une première sous-porteuse à une première fréquence (f1) décalée par rapport à la porteuse ; dans lequel la génération d'une valeur de correction de poursuite comprend des valeurs de correction de poursuite utilisant une largeur de bande de poursuite inférieure à f1.

**11.** Le procédé de la revendication 8, dans lequel l'acceptation du signal de communication comprend l'acceptation d'un signal OFDM avec un signal pilote périodique ; et dans lequel la délivrance du signal de communication numérique comprend l'augmentation de la probabilité d'acquisition de signaux pilote en réponse à la délivrance d'un signal de communication numérique avec des décalages dc corrigés.

12. Le procédé de la revendication 5, dans lequel la génération de la valeur de correction grossière comprend :

la génération d'une erreur représentée par une valeur numérique de correction grossière cumulée ; la conversion de la valeur numérique de correction grossière en une valeur de correction analogique ; et la sommation de la valeur de correction analogique avec une entrée de courant vers le mélangeur.

13. Programme informatique pour l'exécution d'un procédé selon l'une des revendications 1 à 12.

14. Un système pour corriger le décalage en courant continu (dc) dans un signal de communication reçu pour une utilisation dans un récepteur de communications sans fil, le système comprenant :

des moyens pour accepter un signal de communication (104) sur une entrée de signal de mélangeur (102) dans un état de communication ;
des moyens pour mettre en oeuvre le mélangeur (102) avec une correction de valeur grossière (130) ;
des moyens pour accepter un signal de communication analogique issu d'une sortie du mélangeur (106) et la convertir en un signal de communication numérique (110) ;
des moyens pour soustraire une valeur de correction fine (114) du signal de communication converti d'analogique en numérique ; et
des moyens pour délivrer le signal de communication numérique (116) avec des décalages dc corrigés grossier et fin initial.

15. Le système de la revendication 14, comprenant en outre des moyens pour mettre en oeuvre un procédé selon l'une des revendications 1 à 12.

FIG. 1

EP 1 867 057 B1

FIG. 2

EP 1 867 057 B1

FIG. 3

EP 1 867 057 B1

FIG. 4

FIG. 5

FIG. 6

EP 1 867 057 B1

FIG. 7

EP 1 867 057 B1

$T_s$

| OFDM SYMBOL n | OFDM SYMBOL n+1 | OFDM SYMBOL n+2 |
|---|---|---|

T_DC_1

RF SETTLING
TIME

T_DC

TURN LNA OFF

DC LOOP
CONVERGED,
TURN LNA ON

AGC
CONVERGED

FIG. 8

COARSE LOOP TRACKING UPDATE

FIG. 9

FIG. 10

EP 1 867 057 B1

EP 1 867 057 B1

S/W

dc_offset _enable

Acquisition _mode    rf_warm_ up_time    Slotted _mode    sleep    rf_warm_ up_time    Slotted _mode

DC_ OFFSET

dc_offset _start

lna_off_ done    dc_cal_done

SSBI

sleep_start_init    bb_on _stb

SLEEP

agc_enable    agc_ disable    agc_enable

AGC

LNA_OFF    LNA_ON    LNA_OFF    LNA_ON

RF

FIG. 11

FIG. 12A

FROM STEP 1216 (FIG. 12A)

┌─────────────────────────────────────┐ ⌐1217a
│     OPERATING MIXER WITH COARSE      │
│            CORRECTION                │
└─────────────────────────────────────┘

┌─────────────────────────────────────┐ ⌐1217b
│     GENERATING TRACKING CORRECTION   │
└─────────────────────────────────────┘

┌─────────────────────────────────────┐ ⌐1217c
│    SUBTRACTING TRACKING CORRECTION   │
│   FROM DIGITAL COMMUNICATION SIGNAL  │
└─────────────────────────────────────┘

┌─────────────────────────────────────┐ ⌐1217d
│  SUPPLYING SCALED FINE CORRECTIONS AS │
│     UPDATED COARSE CORRECTIONS       │
└─────────────────────────────────────┘

┌─────────────────────────────────────┐ ⌐1218
│ SUPPLYING DIGITAL COMMUNICATION SIGNAL │
│     WITH CORRECTED DC OFFSETS        │
└─────────────────────────────────────┘

COMMUNICATION STATE

## FIG. 12B

(PRIOR ART)

FIG. 13

**EP 1 867 057 B1**

## REFERENCES CITED IN THE DESCRIPTION

### Patent documents cited in the description

- US 6445736 B1